# EUROPÄISCHE PATENTSCHRIFT

(11) **EP 1 435 118 B1**
(45) Veröffentlichungstag und Bekanntmachung des Hinweises auf die Patenterteilung: **02.11.2011**
(21) Anmeldenummer: 02767077.7
(22) Anmeldetag: 02.08.2002
(51) Int. Cl.: H01L 33/48, H01L 33/62

(54) **GEHÄUSE FÜR EIN OBERFLÄCHENMONTIERBARES STRAHLUNGSEMITTIERENDES BAUELEMENT, OBERFLÄCHENMONTIERBARES STRAHLUNGSEMITTIERENDES BAUELEMENT UND ANORDNUNG MIT EINER MEHRZAHL VON OBERFLÄCHENMONTIERBAREN STRAHLUNGSEMITTIERENDEN BAUELEMENTEN**
HOUSING FOR A SURFACE-MOUNTABLE LIGHT-EMITTING COMPONENT, SURFACE-MOUNTABLE LIGHT-EMITTING COMPONENT AND DISPLAY OR ILLUMINATION SYSTEM USING A PLURALITY OF SURFACE-MOUNTABLE LIGHT-EMITTING COMPONENTS
BOITIER POUR UN ELEMENT MONTABLE EN SURFACE EMETTEUR DE LUMIÈRE, ELEMENT MONTABLE EN SURFACE EMETTEUR DE LUMIÈRE ET ENSEMBLE D'AFFICHAGE OU D'ECLAIRAGE DOTE D'ELEMENTS MONTABLES EN SURFACE EMETTEURS DE LUMIÈRE

(30) Priorität: 21.08.2001 DE 10140831; 26.11.2001 DE 10157909
(43) Veröffentlichungstag der Anmeldung: 07.07.2004
(73) Patentinhaber: OSRAM Opto Semiconductors GmbH, 93055 Regensburg (DE)
(72) Erfinder: ARNDT, Karlheinz, 93059 Regensburg (DE); BOGNER, Georg, 93138 Lappersdorf (DE); WAITL, Günter, 93049 Regensburg (DE)
(74) Vertreter: Epping - Hermann - Fischer
(86) Internationale Anmeldenummer: PCT/DE2002/002866
(87) Internationale Veröffentlichungsnummer: WO 2003/019677

(56) Entgegenhaltungen:
- EP-A- 0 274 313
- EP-A- 0 590 336
- EP-A- 1 111 738
- DE-A- 3 835 942
- US-A- 5 874 748
- US-A1- 2002 089 064
- PATENT ABSTRACTS OF JAPAN Bd. 006, Nr. 144 (E-122), 3. August 1982 (1982-08-03) & JP 57 066656 A (MITSUBISHI ELECTRIC CO), 22. April 1982 (1982-04-22)
- PATENT ABSTRACTS OF JAPAN Bd. 009, Nr. 201 (E-336), 17. August 1985 (1985-08-17) & JP 60 066454 A (TOSHIBA KK), 16. April 1985 (1985-04-16)
- PATENT ABSTRACTS OF JAPAN Bd. 2000, Nr. 16, 8. Mai 2001 (2001-05-08) & JP 2001 024237 A (ROHM CO LTD), 26. Januar 2001 (2001-01-26)

## Beschreibung

Die Erfindung betrifft ein Gehäuse nach dem Oberbegriff des patentanspruchs 1, ein oberflächenmontierbares strahlungsemittierendes Bauelement nach dem Oberbegriff des Patentanspruchs 23 sowie eine Anzeige- und/oder Beieucniungsanorctnung mit einer Mehrzahl von oberflächenmontierbaren strahlungsemittierenden Bauelementen nach dem Oberbegriff des Patentanspruchs 29.

Ein strahlungsemittierendes Bauelement der genannten Art ist in Figur 7 schematisch dargestellt und beispielsweise in der EP 0 400 176 A1 beschrieben. Das Bauelement weist einen Gehäusegrundkörper 31 mit einer Auflagefläche 32 auf, in den ein Leiterrahmen 33 eingebettet ist. Teile des Leiterrahmens 33 sind als Anschlußstreifen ausgebildet, die aus dem Gehäusegrundkörper 31 herausragen und im weiteren Verlauf so gebogen sind, daß ihre Anschlußflächen 34 mit der Auflagefläche 32, die die Montageebene des Bauelements festlegt, in einer Ebene liegen. Die Biegungen 35 in den Anschlußstreifen verleihen den Anschlußstreifen gewisse elastische Eigenschaften, so daß einerseits eine stabile, kippfreie Auflage des Bauelements, beispielsweise auf einer Leiterplatte, gewährleistet ist und andererseits mechanische Spannungen, die insbesondere beim Einlöten des Bauelements entstehen können, elastisch abgefangen werden. Da Temperaturänderungen beim Einlöten des Bauelements und auch im Betrieb in der Regel unvermeidlich sind oder deren Vermeidung zumindest einen hohen Aufwand erfordert, kann auf eine gewisse Elastizität des Bauelements, insbesondere auf eine Flexibilität der Anschlußstreifen, nicht verzichtet werden.

Weiterhin müssen die Anschlußstreifen so geformt sein, daß Bauelemente, die als Schüttgut gepackt sind, sich nicht ineinander verhaken. Schließlich muß durch die Anschlußstreifen eine ausreichend stabile Befestigung des Bauelements sichergestellt sein.

Die bekannte gebogene Ausführungsform der Anschlußstreifen erhöht allerdings sowohl vertikal wie horizontal den Platzbedarf für ein solches Bauelement. Durch die gestreckt S-förmigen Biegungen 35 ist in horizontaler Richtung ein gewisser Mindestabstand der Anschlußflächen 34 von dem Gehäusegrundkörper 31 vorgegeben. Dessen Verringerung würde eine stärkere Biegung des Leiterrahmens 33 erfordern und damit die Gefahr erhöhen, daß sich Bauelemente ineinander verhaken. Durch die Biegung 35 des Leiterrahmens 33 zur Montagefläche 32 des Bauelements hin wird zudem das von dem Bauelement beanspruchte Volumen erhöht und die minimale Höhe des Bauelements im eingebauten Zustand festgelegt.

Bei sehr kleinen Bauformen, die beispielsweise eine hohe Pakkungsdichte und/oder flache Bauweise und/oder eine Montage in runden Leiterbahndurchbrüchen, das heißt Bohrungen, ermöglichen soll, ist der Platzbedarf so gering wie möglich zu halten.

Die Druckschrift JP 57-066656 A offenbart einen Halbleiterchip, bei dem auf ein Chip-Pad eines Leiterrahmens ein Siliziumelement montiert wird, der dann mit einem Material 8 umhüllt wird.

Die Druckschrift EP 1 111 738 A offenbart ein Halbleiterbauelement mit einem Halbleiterchip, der auf einem ersten Leiterrahmenteil angeordnet und mit einem zweiten Leiterrahmenteil über einen Draht elektrisch verbunden ist und von einer Schutzumhüllung derart umhüllt ist, dass ein Teil des ersten und ein Teil des zweiten Leiterrahmenteils, die flach sind, aus der Schutzumhüllung herausragen.

Es ist Aufgabe der vorliegenden Erfindung, ein Gehäuse mit einem Leiterrahmen für ein strahlungsemittierendes oberflächenmontierbares Bauelement und ein strahlungsemittierendes oberflächenmontierbares Bauelement sowie eine Anzeige- und/oder Beleuchtungsanordnung mit strahlungsemittierenden oberflächenmontierbaren Bauelementen mit jeweils geringem Platzbedarf anzugeben. Insbesondere ist es Aufgabe der Erfindung, ein Gehäuse mit einem Leiterrahmen zu schaffen, das zudem eine ausreichende Elastizität bei gleichzeitig ausreichender mechanischer Stabilität aufweist.

Diese Aufgabe wird durch den Gegenstand der Patentansprüche 1, 23 bzw. 29 gelöst. Vorteilhafte Weiterbildungen der Erfindung sind Gegenstand der abhängigen Ansprüche.

Der Erfindung liegt die Idee zu Grunde, den Leiterrahmen für ein strahlungsemittierendes Bauelement insbesondere im Bereich außerhalb eines Gehäuses weitestgehend eben auszubilden und dabei so zu formen, daß durch Deformation entstehende Verspannungen in der Ebene des Leiterrahmens elastisch oder plastisch abgefangen werden. Dabei bilden Teile des Leiterrahmens zugleich die Auflagefläche des Bauelements.

Erfindungsgemäß ist insbesondere vorgesehen, einen Leiterrahmen für ein oberflächenmontierbares strahlungsemittierendes Bauelement, beispielsweise einer Lichtemissionsdiode, zu bilden, der mindestens einen Chipanschlußbereich und mindestens einen externen Anschlußstreifen aufweist, wobei der Leiterrahmen eben ausgebildet ist und zwischen dem Chipanschlußbereich und dem externen Anschlußstreifen ein Verformungselement angeordnet ist, das eine elastische oder plastische Verformung des Leiterrahmens in der Ebene des Leiterrahmens ermöglicht. Bevorzugt ist das Verformungselement als Federelement ausgeführt.

Bei einer vorteilhaften Ausgestaltung der Erfindung weist der Leiterrahmen zwei oder mehr Anschlußstreifen auf, wobei jeweils ein Verformungselement oder Federelement zwischen Anschlußstreifen und dem Chipanschlußbereich angeordnet ist.

Durch die ebene Ausführung des Leiterrahmens kann mit Vorteil ein Bauelement gebildet werden, das senkrecht zur Leiterrahmenebene nur sehr geringe Gehäuseausdehnungen und einen sehr geringen Platzbedarf aufweist. Weiterhin kann die externe Anschlußfläche des Bauelements nahe an dem Bauelementgehäuse angeordnet werden, da der horizontale Platzbedarf auf Grund der ebenen Ausführungsform sehr gering ist. Die Verformungs- bzw. Federelemente gewährleisten dabei eine ausreichende Flexibilität gegen Verspannungen und Deformationen, wie sie beispielsweise beim Einlöten oder auf Grund von thermischer Belastung im Betrieb des Bauelements entstehen können.

Mit der erfindungsgemäßen Ausführung des Leiterrahmens, Gehäuses bzw. Bauelements kann vorteilhafterweise vermieden werden, daß Leiterrahmenteile erst nach Herstellen eines Bauelementgehäuses gebogen werden müssen. Dies ist insbesondere bei durch Umpressen oder Umspritzen hergestellten Gehäusekörpern von Bedeutung. Die Gefahr der Delamination von Gehäuse und Leiterrahmen wird dadurch verringert, was insbesondere bei stark miniaturisierten Gehäusen verstärkt zur Geltung kommt.

Bei einer vorteilhaften Weiterbildung der Erfindung ist das Verformungselement als Federstreifen ausgebildet, der ausreichend schmal ist, um die erforderliche Flexibilität des Leiterrahmens zu gewährleisten. Vorzugsweise ist dieses Verformungselement schmäler als der angrenzende Anschlußstreifen ausgeführt und verläuft quer zur Haupterstreckungsrichtung des Leiterrahmens. Durch diesen verlauf des Federstreifens wird erreicht, daß mechanische Spannungen in der Ebene des Leiterrahmens weitgehend unabhängig von ihrer Richtung gut abgefedert werden können. Weiterhin ermöglicht diese Ausführungsform eine einfache und kostengünstige Herstellung des Leiterrahmens, indem der Leiterrahmen aus einem Blech oder einer Folie ausgestanzt wird. Anschlußstreifen und angrenzende Verformungselemente, sowie Teile des Chipanschlußbereichs sind dabei einstückig gebildet und können in einem Arbeitsschritt aus einem Blech oder einer Folie gestanzt sein.

Bei einer vorteilhaften Weiterbildung der Erfindung weist der Anschlußstreifen einen Vorsprung und/oder ein Gehäusekörper einen Vorsprung oder eine Nut auf, der bzw. die eine Verankerung des Anschlußstreifens in dem Gehäusekörper ermöglicht. Damit wird die Gefahr einer Verbiegung des Leiterrahmen bzw. der Anschlußstreifen senkrecht zur Leiterrahmenebene verringert.

Der Chipanschlußbereich ist vorzugsweise zweiteilig mit einem Chipanschlußteil und einem Drahtanschlußteil ausgeführt, wobei der Chipanschlußteil zur Montage eines strahlungsemittierenden Chips vorgesehen ist. Die weitere Kontaktierung des Chips erfolgt mittels einer Drahtverbindung zu dem Drahtanschlußteil.

Zwischen dem Verformungs- bzw. Federelement und dem Chipanschlussbereich weist der Leiterrahmen vorzugsweise mindestens ein Halteelement zur Fixierung des Chipanschlußbereiches in einem Bauelementgehäuse auf. Dieses dient insbesondere zur Zugentlastung des Chipanschlussbereiches. Ein solches Halteelmente ist beispielsweise mittels einer Aussparung oder eines Durchbruches im Leiterrahmen realisiert, in die bzw. den das Bauelementgehäuse eingreift.

Bei einer vorteilhaften Ausgestaltung der Erfindung ist der Leiterrahmen teilweise in ein Gehäuse eingebettet, wobei die Verformungs- bzw. Federelemente mit den angrenzenden Anschlußstreifen aus dem Gehäuse herausgeführt sind. Weiterhin kann das Gehäuse ein Strahlungsaustrittsfenster in Form einer geeignet geformten Ausnehmung aufweisen, in der der Chipanschlußbereich des Leiterrahmens angeordnet ist. Vorzugsweise sind die Seitenflächen des Strahlungsaustrittsfensters als Strahlungsreflektor ausgebildet. Alternativ kann das Gehäuse auch aus einem strahlungsdurchlässigen Material bestehen und den strahlungsemittierenden Chip vollständig einhüllen.

Eine bevorzugte Weiterbildung eines erfindungsgemäßen Gehäuses weist umfangsseitige Vorsprünge auf, die in der Aufsicht mit den Verformungs- bzw. Federelementen des Leiterrahmens teilweise überlappen. Vorteilhafterweise wird so die Gefahr einer Verbiegung der Anschlußstreifen bzw. der Verformungs- oder Federelemente senkrecht zur Leiterrahmenebene reduziert. Dazu können zusätzlich oder alternativ Vorsprünge an den Anschlußstreifen wie bereits beschrieben gebildet sein, die in den Gehäusekörper hineinragen.

Bei einer besonders bevorzugten Ausführungsform weist der Gehäusekörper parallel zur Ebene des Lötanschlußstreifens eine im Wesentlichen kreisrunde oder ovale Querschnittsform auf.

Bei einem erfindungsgemäßen strahlungsemittierenden Bauelement ist auf dem Chipanschlußbereich bzw. dem Chipanschlußteil des Leiterrahmens ein strahlungsemittierender Chip, beispielsweise ein Halbleiterchip befestigt. Der Halbleiterchip und Teile des Leiterrahmens sind von einem Gehäuse der beschriebenen Art umgeben.

Ist der Chip innerhalb eines Strahlungsaustrittfensters angeordnet, so kann dieses vorteilhafterweise mit einer dem Chip umhüllenden, transparenten Masse, vorzugsweise einer Kunststoffmasse gefüllt sein. Diese Umhüllung dient dem Schutz des Chips und ermöglicht zudem die Ausbildung eines dem strahlungsemittierenden Chip nachgeordneten optischen Elements, beispielsweise in Form einer Linsenoberfläche. Als Umhüllung eignen sich insbesondere Reaktionsharze wie Epoxidharze, Acrylharze oder Silikonharze oder eine Mischung dieser Harze.

Weitere Merkmale, Vorzüge und Zweckmäßigkeiten der Erfindung werden nachfolgend an Hand von fünf Ausführungsbeispielen näher erläutert.

Es zeigen:
Figur 1 eine schematische Aufsicht auf ein Ausführungsbeispiel eines erfindungsgemäßen Leiterrahmens,
Figur 2 eine schematische Aufsicht auf ein erstes Ausführungsbeispiel eines erfindungsgemäßen Gehäuses,
Figuren 3a; 3b und 3c eine schematische Aufsicht, Seitenansicht und Unteransicht eines zweiten Ausführungsbeispiels eines erfindungsgemäßen Gehäuses,
Figur 4 eine schematische perspektivische Ansicht eines Ausführungsbeispiels eines erfindungsgemäßen Bauelements,
Figur 5 eine schematische Schnittansicht eines ersten Ausführungsbeispiels einer erfindungsgemäßen Mehrfachanordnung strahlungsemittierender Bauelemente,
Figur 6 eine schematische Schnittansicht eines zweiten Ausführungsbeispiels einer erfindungsgemäßen Mehrfachanordnung strahlungsemittierender Bauelemente und
Figur 7 ein oberflächenmontierbares Bauelement nach dem Stand der Technik.

Gleiche oder gleichwirkende Elemente sind in den Figuren mit denselben Bezugszeichen versehen.

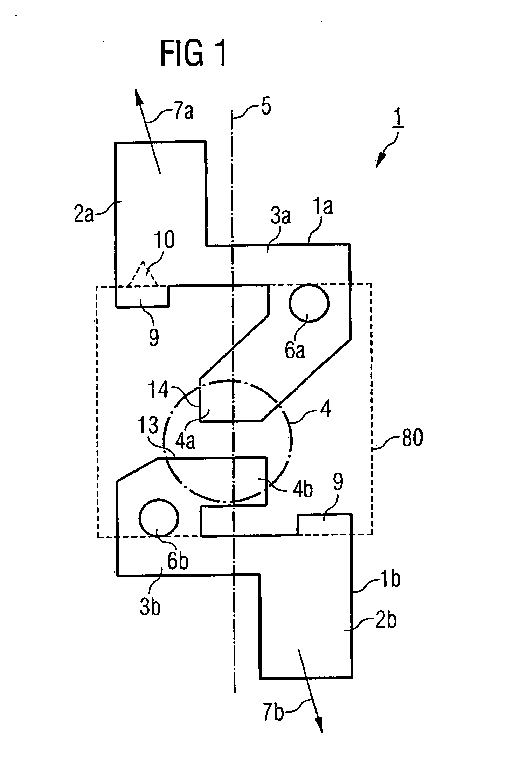

Der in Figur 1 dargestellte Leiterrahmen 1 ist eben und zweiteilig ausgeführt. Beide Leiterrahmenteile 1a und 1b weisen jeweils einen Anschlußstreifen 2a, 2b auf, an den ein Verformungselement 3a, 3b grenzt. Bevorzugt ist das Verformungselement als Federelement ausgeführt.

Von den Verformungselementen 3a, 3b erstrecken sich beide Leiterrahmenteile 1a, 1b zu einem Chipanschlußbereich 4. Dabei kann beispielsweise das eine der beiden in den Chipanschlußbereich 4 ragenden Leiterrahmenteile 1a als Chipanschlußteil 14 mit einer Montagefläche für einen Chip, vorzugsweise einen strahlungsemittierenden Halbleiterchip, vorgesehen sein. Entsprechen kann das andere Leiterrahmenteil 1b als Drahtanschlußteil 13 ausgebildet sein und eine Drahtanschlußfläche aufweisen, die zum elektrischen Kontaktieren des Chips dient.

Die Verformungselemente bzw. Federelemente 3a, 3b sind in Form schmaler Streifen ausgeführt, deren Breite schmäler ist als die Breite der angrenzenden Anschlußstreifen 2a, 2b. Diese Federstreifen verlaufen senkrecht zur Längsachse 5 des Leiterrahmens 1, die mit der Haupterstreckungsrichtung des Leiterrahmens zusammenfällt.

Durch die beschriebene Formgebung wird dem ebenen Leiterrahmen 1 eine Flexibilität verliehen, so daß Verspannungen in der Leiterrahmenebene, beispielsweise durch Zug in den gezeigten Richtungen 7a, 7b, wie sie bei oder nach dem Einlöten auf Grund verschiedener thermischer Ausdehnungskoeffizienten auftreten können, vermittels der Verformungselemente 3a, 3b abgefangen werden. Dadurch wird insbesondere eine Übertragung der Spannungen auf Teile eines einen solchen Leiterrahmen einbettenden Gehäusekörpers 80 (in Figur 1 durch den gestrichelten Umriß angedeutet) vermieden, die zu Rissen oder anderweitigen Beschädigungen des Gehäuses führen können.

In dem Leiterrahmen 1 sind ferner kreisförmige Durchbrüche 6a, 6b gebildet, die die Halterung des Leiterrahmens in einem Gehäuse verbessern. Durch diese Durchbrüche 6a, 6b können entsprechend geformte Zapfen eines Gehäusekörpers 80 geführt sein, die eine Verschiebung des Leiterrahmens innerhalb Gehäuses weitestgehend unterbinden. Ist der Gehäusekörper 80 beispielsweise zumindest teilweise durch Umhüllen des Leiterrahmens 1 mit einer Formmasse, beispielsweise vermittels eines Spritzguß- oder Spritzpreßgußverfahrens, gebildet, so füllt die Formmasse die Durchbrüche aus, wodurch die oben genannten Zapfen ausgebildet werden, die im festen Zustand für die zusätzliche Halterung des Leiterrahmens im Gehäuse sorgen.

Weiterhin weist der Anschlußstreifen 2b einen Vorsprung 9 auf, der eine zusätzliche Verankerung des Leiterrahmens im Gehäusekörper 80 ermöglicht und insbesondere dazu dient, eine Verbiegung des Anschlußstreifens 2b und/oder des angrenzenden Verformungselementes 3b aus der Leiterrahmenebene heraus zu verhindern. Dazu kann, wie im folgenden noch genauer beschrieben wird, zusätzlich oder alternativ auch ein Vorsprung 10 an einem Gehäuse dienen, der ebenfalls eine solche Verbiegung verhindert.

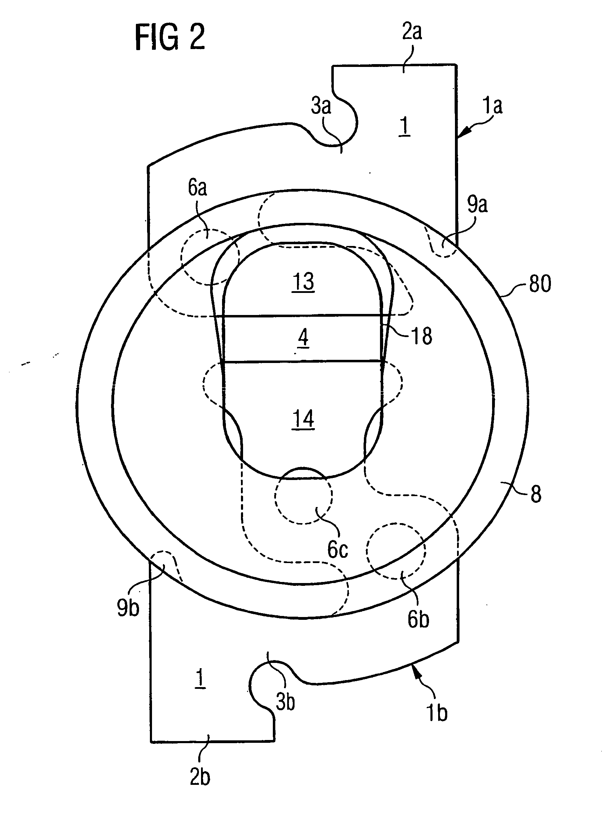

In Figur 2 ist eine schematische Aufsicht auf ein Ausführungsbeispiel eines erfindungsgemäßen Gehäuses für ein strahlungsemittierendes Bauelement gezeigt.

Ein Gehäusekörper 80 umfaßt hierbei einen betreffend die äußere Kontour weitgehend rotationssymmetrischen Gehäusegrundkörper 8 mit einem in der Abbildung kreisförmigen Umriß, in den ein Leiterrahmen 1 teilweise eingebettet ist. Der Leiterrahmen 1 ist, wie im vorigen Ausführungsbeispiel, eben und zweiteilig gebildet, wobei die beiden Leiterrahmenteile jeweils einen externen Anschlußstreifen 2a, 2b und ein daran anschließendes Verformungselement 3a, 3b, sowie ein Chipanschlußteil 14 bzw. ein Drahtanschlußteil 13 aufweisen. Chipanschlußteil 14 und Drahtanschlußteil 13 sind voneinander beabstandet in einem gemeinsamem Chipanschlußbereich 4 in dem Gehäuse angeordnet.

Weiterhin ist an den Anschlußstreifen 2a, 2b jeweils ein Vorsprung 9a, 9b geformt, der in den Gehäusegrundkörper 8 hineinragt und so eine Verbiegung des Leiterrahmens 1 senkrecht zur Leiterrahmenebene verhindert.

Der Gehäusegrundkörper 8 besteht vorzugsweise aus einer Formmasse und ist durch Umhüllen des Leiterrahmens 1 mit dieser Formmasse, beispielsweise vermittels eines Spritzguß- oder Spritzpreßgußverfahrens hergestellt. Die Formmasse füllt dabei auch die Durchbrüche 6a, 6b und 6c in dem Leiterrahmen 1 aus, so daß eine mechanisch stabile Verankerung des Leiterrahmens 1 in dem Gehäusegrundkörper 8 gewährleistet ist.

Der Gehäusegrundkörper 8 weist ferner ein Strahlungsaustrittsfenster 12 in Form einer kegelstumpfartigen, sich in Richtung der Hauptabstrahlungsrichtung erweiternden Ausnehmung auf, in die das Chipanschlußteil 14 bzw. das Drahtanschlußteil 13 des Leiterrahmens hineinragen, das heißt, mit einer Oberfläche zumindest an den Innenraum der Ausnehmung grenzen, und insbesondere zumindest einen Teil der Bodenfläche des Strahlungsaustrittsfensters 12 bilden. Dazu ist in dem Strahlungsaustrittsfenster 12 eine gesonderte Aussparung 18 gebildet, deren Grundfläche den Chipanschlußbereich 4 bildet und die Montageebene für einen Chip bzw. eine Drahtverbindung definiert.

Die Seitenwand des Strahlunsaustrittsfensters, die die Bodenfläche der Ausnehmung mit der äußeren Fläche des Gehäusegrundkörpers 8 verbindet, ist derart ausgeführt, daß sie als Reflektorfläche für eine von dem Chip 16 abgestrahlte elektromagnetische Strahlung wirkt. Sie kann je nach gewünschtem Abstrahlverhalten eben oder konkav sein.

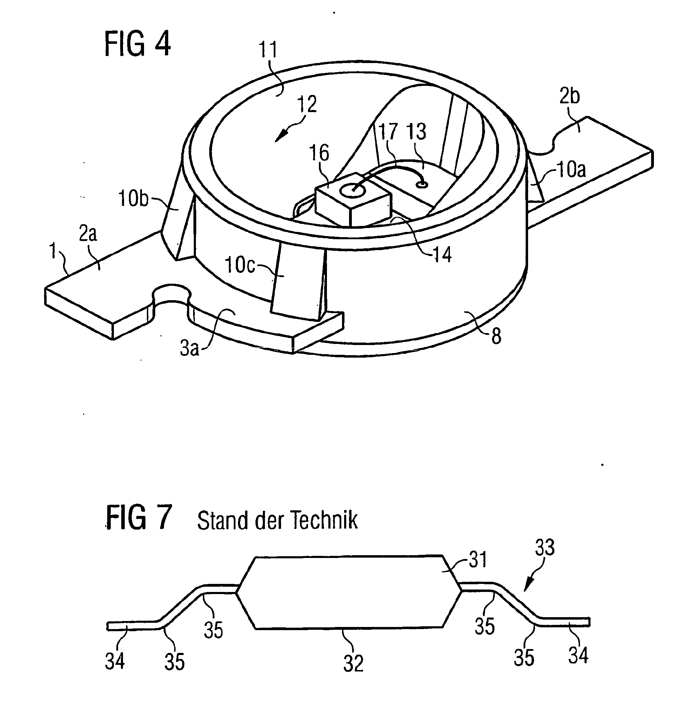

Die Seitenwand ist vorzugsweise derart ausgeführt, daß der Chip 16 mittig in der durch sie gebildeten Reflektorwanne angeordnet ist, und daß sie besonders bevorzugt im Wesentlichen bis an den Montagebereich für den Chip auf dem Leiterrahmen 1 herangeführt ist. Letzteres bedeutet, daß nur dieser Montagebereich alleine im Wesentlichen die gesamte Bodenfläche der kegelstumpfartigen Ausnehmung darstellt. Das heißt, daß die Bodenfläche bevorzugt nur so groß ist, wie für die Chipmontage nötig ist. Um dies weitestgehend zu erreichen, ist in der Seitenwand eine Aussparung 18 für eine Drahtverbindung 17 vom Drahtanschlußteil 13 zum Chip 16 vorgesehen (vgl. Figur 4) .

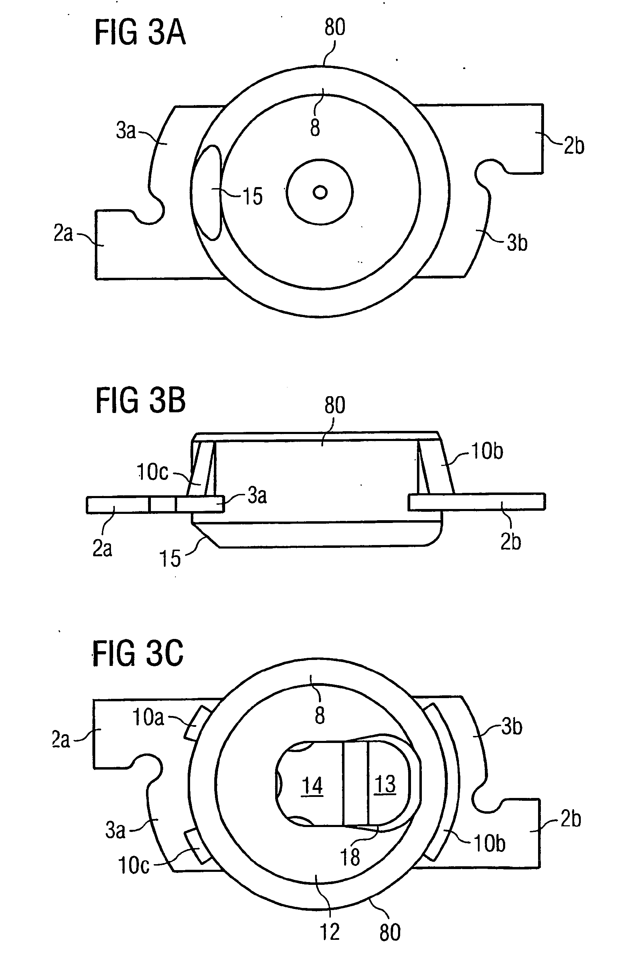

In Figur 3 ist ein weiteres Ausführungsbeispiel eines erfindungsgemäßen Gehäuses gezeigt. In Figur 3a ist die Unteransicht, in Figur 3b die Seitenansicht und in Figur 3c die Aufsicht des Gehäuses dargestellt.

Im Unterschied zu den vorher beschriebenen Ausführungsbeispielen sind umfangsseitig an dem Gehäuse Vorsprünge 10a, 10b und 10c angeordnet, die eine Verbiegung des Leiterrahmens 1 senkrecht zur Leiterrahmenebene verhindern (vgl. Figuren 3b und 3c). Das Gehäuse ist insbesondere für ein LED-Bauelement vorgesehen. Zur Markierung des Kathodenanschlusses des Leiterrahmens 1 weist das Gehäuse auf einer Seite eine Anschrägung 15 sowie zwei getrennte Gehäusevorsprünge 10a, 10c auf, während gegenüberliegend ein einziger breiterer Vorsprung 10b angeformt ist.

Die Vorsprünge 10a, 10b und 10 c sind dabei so angeordnet, daß sie in der Aufsicht bzw. in der Unteransicht mit den Verformungs- bzw. Federelementen 3a, 3b überlappen und so eine vertikale Verbiegung der Verformungselemente behindern.

In Figur 4 ist perspektivisch ein Ausführungsbeispiel eines erfindungsgemäßen strahlungsemittierenden Bauelements dargestellt. Das Gehäuse des Bauelements entspricht dem vorigen Ausführungsbeispiel. Auf dem von dem Chipanschlußteil 14 gebildeten Bereich der Grundfläche des Strahlungsaustrittfensters 12 ist ein strahlungsemittierender Chip 16, beispielsweise ein Halbleiterchip wie eine Halbleiter-LED oder ein Halbleiterlaser befestigt, beispielsweise aufgelötet oder mittels eines elektrisch leitfähigen Haftmittels aufgeklebt.

Auf der von dem Leiterrahmen 1 abgewandten Vorderseite weist der Halbleiterchip 16 eine Kontaktfläche auf, von der aus eine Drahtverbindung 17 zu dem Drahtanschlußteil 13 geführt ist. Die schrägstehende Seitenfläche 11 des Strahlungsaustrittfensters 12 dient als Reflektor für eine von dem Halbleiterchip 16 zur Seite ausgesandte Strahlung.

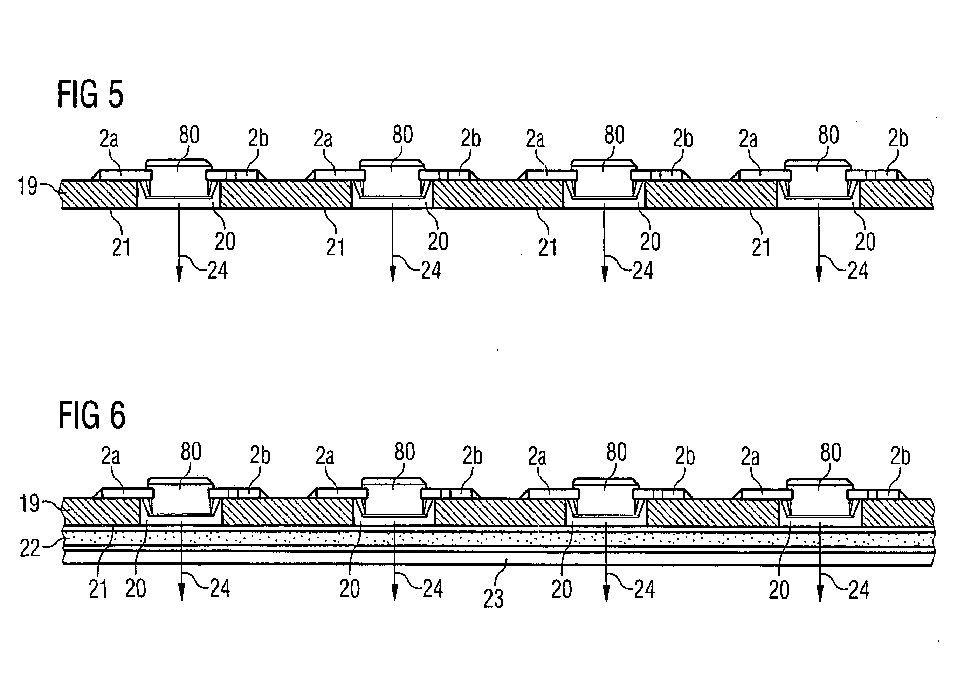

In Figur 5 ist eine Mehrfachanordnung erfindungsgemäßer Bauelemente gezeigt. In einem Träger 19, beispielsweise einer Platine, ist eine Mehrzahl von Durchbrüchen 20 gebildet. Weiterhin weist der Träger eine Abstrahlungsseite 21 auf.

Auf der der Abstrahlungsseite gegenüberliegenden Seite des Träger ist eine Mehrzahl erfindungsgemäßer strahlungsemittierender Bauelemente befestigt, wobei jeweils ein Teil des Gehäusekörpers 80 eines strahlungsemittierenden Bauelements gemäß Figur 4 in einen der Durchbrüche 20 hineinragt und die Abstrahlungsrichtung 24 durch die Durchbrüche 20 hindurch verläuft.

Die Anschlußstreifen 2a, 2b der jeweiligen Leiterrahmen der Bauelemente liegen auf der der Abstrahlungsseite 21 gegenüberliegenden Oberfläche des Trägers 19 auf. Zur Befestigung der Bauelemente können Klebeverbindungen oder Lötverbindungen dienen. Auf Grund des eben ausgebildeten Leiterrahmens, der insbesondere keine Biegungen aufweist, ist der Platzbedarf horizontal und vertikal deutlich geringer als bei Bauelementen nach dem Stand der Technik. Insbesondere ermöglicht die Erfindung eine teilweise versenkte Montage der Bauelemente.

Auf Grund der beispielsweise als Federstreifen in dem Leiterrahmen ausgebildeten Verformungselemente 3a, 3b ist der Leiterrahmen ausreichend flexibel, um Verspannungen und Verformungen elastisch oder plastisch abzufangen, ohne daß schädliche Verspannungen auf das Gehäuse oder einen darin befindlichen strahlungsemittierenden Chip übertragen werden. Diese Montageanordnung ist insbesondere für dicht gepackte flache Anzeigemodule geeignet.

Vorzugsweise ist der Träger oder zumindest die abstrahlungsseitige Oberfläche strahlungsabsorbierend, beispielsweise geschwärzt ausgeführt, so daß der Kontrast der einzelnen strahlungsemittierenden Bauelemente gegenüber der Umgebung erhöht wird. Dies ist insbesondere bei Mehrfachanordnungen vorteilhaft, die als Anzeigevorrichtung vorgesehen sind.

In Figur 6 ist eine weitere Mehrfachanordnung erfindungsgemäßer Bauelemente gezeigt. Im Unterschied zur vorangehenden Mehrfachanordnung ist die in Figur 6 gezeigte Mehrfachanordnung insbesondere als Hintergrundbeleuchtung, beispielsweise für eine Flüssigkristallanzeige, geeignet.

Auf einem Träger 19 sind wie im vorigen Ausführungsbeispiel erfindungsgemäße strahlungsemittierende Bauelemente teilweise versenkt montiert. Abstrahlungsseitig ist dem Träger bzw. den Bauelementen eine Streuplatte 22 nachgeordnet. Weiterhin ist der Träger 19 oder zumindest die abstrahlungsseitige Oberfläche des Trägers 19 vorzugsweise gleichmäßig diffus reflektierend, beispielsweise weiß ausgeführt. Dadurch wird eine weitgehend homogene Hinterleuchtung in äußerst flacher Bauweise ermöglicht. Der Streuplatte nachgeordnet ist beispielsweise eine zu beleuchtende LCD-Anzeige 23.

Der Träger kann sowohl, wie oben beschrieben, starr als auch flexibel, zum Beispiel in Form einer Kunststoff- oder Keramikfolie ausbildet sein, so daß ein Hinterleuchtungs- oder Anzeigemodul auf einfache Weise verschiedenen Formen angepaßt und vorteilhafterweise sogar an sich verändernde Flächen montiert werden kann.

Die Erläuterung der Erfindung an Hand der gezeigten Ausführungsbeispiele ist selbstverständlich nicht als Beschränkung der Erfindung hierauf zu verstehen. Beispielsweise kann der Chip unmittelbar auf einer Chipmontagefläche des Gehäusegrundkörpers 8 montiert, zum Beispiel geklebt, sein und der Chip ausschließlich mittels Drahtverbindungen mit dem Leiterrahmen elektrisch verbunden sein. Der Chip kann ebenso auf einem separaten thermischen Anschluß montiert sein, der in den Gehäusekörper eingebettet ist, und wiederum mittels Drahtverbindungen elektrisch an den Leiterrahmen angeschlossen sein. All diese Ausführungsformen verlassen den Grundgedanken der vorliegenden Erfindung nicht.

## Patentansprüche

1. Gehäuse für ein oberflächenmontierbares strahlungsemittierendes Bauelement, mit
- einem Gehäusekörper (80) und
- einem Leiterrahmen (1) mit mindestens einem Chipanschlußbereich (4) und mindestens einem mit diesem elektrisch verbundenen externen Anschlußstreifen (2a,2b), wobei zwischen dem Chipanschlußbereich (4) und dem externen Anschlußstreifen (2a,2b) ein Verformungselement (3a, 3b) ausgebildet ist, das vollständig in ein und derselben Ebene des Leiterrahmens (1) verläuft wie der externe Anschlußstreifen (2a,2b) und in paralleler Richtung zu einer Montageebene des Gehäuses eine Bewegung des externen Anschlußstreifens relativ zum Chipanschlußbereich (4) ermöglicht, und wobei
der Leiterrahmen derart in den Gehäusekörper (80) eingebettet ist, dass der externe Anschlußstreifen aus diesem herausragt,
**dadurch gekennzeichnet, daß**
das Verformungselement (3a, 3b) zumindest teilweise aus dem Gehäusekörper herausragt.

2. Gehäuse nach Anspruch 1,
**dadurch gekennzeichnet, daß**
das Verformungselement (3a, 3b) ein Federelement ist.

3. Gehäuse nach Anspruch 1 oder 2,
**dadurch gekennzeichnet, daß**
der Leiterrahmen zwischen dem Verformungselement (3a,3b) und dem Chipanschlußbereich (4) ein Halteelement (6a,6b) aufweist zur Fixierung des Chipanschlußbereiches (4) in dem Gehäuse.

4. Gehäuse nach Anspruch 3,
**dadurch gekennzeichnet, daß**
zwischen dem Chipanschlußbereich (4) und dem Halteelement (6a,6b) ein weiteres Halteelement (6c) angeordnet ist.

5. Gehäuse nach Anspruch 3 oder 4,
**dadurch gekennzeichnet, daß**
das Halteelement bzw. mindestens eines der Halteelemente (6a,6b) ein Durchbruch oder eine Aussparung im Bereich zwischen dem Verformungselement (3a,3b) und dem Chipanschlußbereich (4a,4b) ist, in den bzw. die der Gehäusekörper (80) eingreift.

6. Gehäuse nach mindestens einem der vorigen Ansprüche,
**dadurch gekennzeichnet, daß**
das Verformungselement (3a,3b) oder der externe Anschlußstreifen (2a,2b) einen Führungsteil (9,9a,9b), insbesondere einen Vorsprung (9a,9b) aufweist, der insbesondere vom Gehäusekörper (80) derart gestützt ist, daß er gegen ein Verbiegen des externen Anschlußstreifens (2a,2b) insbesondere zur Vorderseite des Gehäuses hin wirkt.

7. Gehäuse nach mindestens einem der vorigen Ansprüche,
**dadurch gekennzeichnet, daß**
der Leiterrahmen (1) insgesamt eben ausgebildet ist.

8. Gehäuse nach mindestens einem der vorigen Ansprüche,
**dadurch gekennzeichnet, daß**
der Leiterrahmen (1) zwei externe Anschlußstreifen (2a, 2b) aufweist.

9. Gehäuse nach Anspruch 8,
**dadurch gekennzeichnet, daß**
zwischen den externen Anschlußstreifen (2a, 2b) und dem Chipanschlußbereich (4) jeweils ein Verformungselement (3a, 3b) angeordnet ist.

10. Gehäuse nach einem der vorigen Ansprüche,
**dadurch gekennzeichnet, daß**
das Verformungselement (3a, 3b) einen Federstreifen umfaßt, dessen Streifenbreite geringer als die Breite des angrenzenden externen Anschlußstreifens (2a, 2b) ist.

11. Gehäuse nach Anspruch 10,
**dadurch gekennzeichnet, daß**
der Federstreifen quer zur Haupterstreckungsrichtung des Leiterrahmens (1) verläuft.

12. Gehäuse nach einem der vorigen Ansprüche,
**dadurch gekennzeichnet, daß**
der Chipanschlußbereich (4) ein Chipmontageteil (14) und ein davon beabstandet angeordnetes Drahtanschlußteil (13) umfaßt.

13. Gehäuse nach einem der vorigen Ansprüche,
**dadurch gekennzeichnet, daß**
der externe Anschlußstreifen (2a, 2b), das Verformungselement (3a, 3b) und ein diesem zugeordneter Teilbereich des Chipanschlußbereichs (4) des Leiterrahmens (1) einstückig ausgebildet sind.

14. Gehäuse nach einem der vorigen Ansprüche,
**dadurch gekennzeichnet, daß**
der Leiterrahmen (1) mit einer die Löt- oder Bondeigenschaften verbessernden Oberflächenvergütung versehen ist.

15. Gehäuse nach Anspruch 6,
**dadurch gekennzeichnet,**
**daß** am Gehäusekörper (80) mindestens ein Führungselement, insbesondere ein Führungsvorsprung (10a,10b,10c) oder eine Führungsnut vorgesehen ist, das mit dem Führungsteil (9,9a,9b) des Leiterrahmens zusammenwirkt.

16. Gehäuse nach Anspruch 15,
**dadurch gekennzeichnet, daß**
der Gehäusekörper (80) einen Gehäusegrundkörper (8) aufweist, in den der Leiterrahmen (1) derart eingebettet ist, daß der externe Anschlußstreifen (2a, 2b) und zumindest teilweise das Verformungselement (3a, 3b) aus dem Gehäusegrundkörper (8) herausragen.

17. Gehäuse nach Anspruch 16,
**dadurch gekennzeichnet, daß**
der Gehäusegrundkörper (8) parallel zur Ebene des externen Anschlußstreifens (2a,2b) eine kreisrunde oder ovale Querschnittsform aufweist.

18. Gehäuse nach Anspruch 16 oder 17,
**dadurch gekennzeichnet, daß**
das Führungselement am Gehäusegrundkörper (8) angeordnet, insbesondere an diesem angeformt ist.

19. Gehäuse nach einem der Ansprüche 15 bis 18,
**dadurch gekennzeichnet, daß**
der Gehäusekörper (80) bzw. der Gehäusegrundkörper (8) als Führungselement einen Vorsprung (10) aufweist, der mit dem zu stützenden Verformungselement (3a, 3b) oder externen Anschlußstreifen (2a,2b) überlappt.

20. Gehäuse nach einem der Ansprüche 15 bis 19,
**dadurch gekennzeichnet, daß**
der Gehäusekörper (80) bzw. der Gehäusegrundkörper (8) eine Nut aufweist, in den der Führungsteil (9,9a,9b) des Verformungselements (3a,3b) bzw. des externen Anschlußstreifens (2a, 2b) hineinragt.

21. Gehäuse nach einem der Ansprüche 1 bis 20,
**dadurch gekennzeichnet, daß**
der Gehäusekörper (80) bzw. der Gehäusegrundkörper (8) aus einer Formmasse, insbesondere aus einem Thermoplastmaterial gefertigt ist.

22. Gehäuse nach einem der Ansprüche 1 bis 21,
**dadurch gekennzeichnet, daß**
das Gehäuse ein Strahlungsaustrittsfenster (12) aufweist, in dem der Chipanschlußbereich (4) des Leiterrahmens (1) angeordnet ist.

23. Oberflächenmontierbares strahlungsemittierendes Bauelement mit einem strahlungsemittierenden Chip (16),
**dadurch gekennzeichnet, daß**
es ein Gehäuse nach einem der Ansprüche 1 bis 22 und einem strahlungsemittierenden Chip aufweist.

24. Oberflächenmontierbares strahlungsemittierendes Bauelement nach Anspruch 23,
**dadurch gekennzeichnet, daß**
das Gehäuse ein Strahlungsaustrittsfenster (12) aufweist, in dem der Chipanschlußbereich (4) des Leiterrahmens (1) angeordnet ist und
das Strahlungsaustrittsfenster (12) zumindest teilweise von Seitenflächen begrenzt ist, die derart ausgebildet sind, daß sie zumindest für einen Teil einer von dem im Strahlungsaustrittsfenster (12) angeordneten strahlungsemittierenden Chip ausgesandten Strahlung als Strahlungsreflektor (11) wirken.

25. Oberflächenmontierbares strahlungsemittierendes Bauelement nach Anspruch 23 oder 24,
**dadurch gekennzeichnet, daß**
im Chipanschlußbereich (4a,4b) auf dem Leiterrahmen (1) oder gegebenenfalls auf dem Gehäusegrundkörper (8) der strahlungsemittierende Chip (16) befestigt ist.

26. Oberflächenmontierbares strahlungsemittierendes Bauelement nach einem der Ansprüche 23 bis 25,
**dadurch gekennzeichnet, daß**
der strahlungsemittierende Chip (16) ein Halbleiterchip ist.

27. Oberflächenmontierbares strahlungsemittierendes Bauelement nach Anspruch 25 oder 26,
**dadurch gekennzeichnet, daß**
der Chip (16) zumindest teilweise mit einer strahlungsdurchlässigen Masse, insbesondere einer Kunststoffmasse umhüllt ist.

28. Oberflächenmontierbares strahlungsemittierendes Bauelement nach Anspruch 27,
**dadurch gekennzeichnet, daß**
die strahlungsdurchlässige Masse ein Gießharz oder eine Pressmasse auf der Basis eines Reaktionsharzes, insbesondere ein Epoxidharz, Acrylharz oder Silikonharz oder eine Mischung dieser Harze ist.

29. Anordnung mit einer Mehrzahl von oberflächenmontierbaren strahlungsemittierenden Bauelementen nach einem der Ansprüche 23 bis 28,
**dadurch gekennzeichnet, daß**
ein Träger (19) mit einer Mehrzahl von Durchbrüchen (20) vorgesehen ist und die strahlungsemittierenden Bauelemente jeweils mit den externen Anschlußstreifen (2a,2b) an einer Bauelementseite des Trägers befestigt sind, derart, daß ihr Gehäusekörper (80) bzw. Gehäusegrundkörper (8) jeweils in einen der Durchbrüche (20) ragt oder diesen durchragt.

30. Anordnung nach Anspruch 29,
**dadurch gekennzeichnet, daß**
der Träger (19) eine Abstrahlungsseite (21) aufweist, die sich an dessen der Bauelementseite gegenüberliegenden Seite befindet und die Bauelemente jeweils mit ihrer Vorderseite in bzw.durch die Durchbrüche (20) ragen.

31. Anordnung nach Anspruch 30,
**dadurch gekennzeichnet, daß**
die abstrahlungsseitige Oberfläche des Trägers (19) strahlungsabsorbierend, insbesondere geschwärzt, ist.

32. Anordnung nach Anspruch 30,
**dadurch gekennzeichnet, daß**
die abstrahlungsseitige Oberfläche des Trägers (19) diffus reflektierend, insbesondere weiß, ist.

33. Anordnung nach einem der Ansprüche 30 bis 32,
**dadurch gekennzeichnet, daß**
abstrahlungsseitig dem Träger (19) eine Streuplatte (22) nachgeordnet ist.

34. Anordnung nach einem der Ansprüche 30 bis 33,
**dadurch gekennzeichnet, daß**
abstrahlungsseitig dem Träger (19) eine Flüssigkristallanzeige nachgeordnet ist.

35. Anordnung nach einem der Ansprüche 29 bis 34,
**dadurch gekennzeichnet, daß**
der Träger (19) flexibel ausgebildet ist.

36. Anordnung nach einem der Ansprüche 29 bis 35,
**dadurch gekennzeichnet, daß**
auf dem Träger (19) elektrische Leitungsstrukturen ausgebildet sind.

## Claims

1. Housing for a surface-mountable radiation-emitting component, having
- a housing body (80) and
- a leadframe (1) having at least one chip connection region (4) and at least one external connection strip (2a, 2b) electrically connected to the latter,
a deformation element (3a, 3b) being formed between the chip connection region (4) and the external connection strip (2a, 2b), which deformation element runs completely in one and the same plane of the leadframe (1) as the external connection strip (2a, 2b) and in a direction parallel to a mounting plane of the housing enables a movement of the external connection strip relative to the chip connection region (4), and the leadframe being embedded in the housing body (80) in such a way that the external connection strip projects from it,
**characterized in that**
the deformation element (3a, 3b) projects at least partly from the housing body.

2. Housing according to Claim 1,
**characterized in that**
the deformation element (3a, 3b) is a spring element.

3. Housing according to Claim 1 or 2,
**characterized in that**
the leadframe has a holding element (6a, 6b) for fixing the chip connection region (4) in the housing between the deformation element (3a, 3b) and the chip connection region (4).

4. Housing according to Claim 3,
**characterized in that**
a further holding element (6c) is arranged between the chip connection region (4) and the holding element (6a, 6b).

5. Housing according to Claim 3 or 4,
**characterized in that**
the holding element or at least one of the holding elements (6a, 6b) is a perforation or a cutout in the region between the deformation element (3a, 3b) and the chip connection region (4a, 4b) into which the housing body (80) engages.

6. Housing according to at least one of the preceding claims,
**characterized in that**
the deformation element (3a, 3b) or the external connection strip (2a, 2b) has a guide part (9, 9a, 9b), in particular a projection (9a, 9b), which is supported, in particular by the housing body (80), in such a way that it acts against a bending of the external connection strip (2a, 2b), in particular toward the front side of the housing.

7. Housing according to at least one of the preceding claims,
**characterized in that**
the leadframe (1) is formed in planar fashion overall.

8. Housing according to at least one of the preceding claims,
**characterized in that**
the leadframe (1) has two external connection strips (2a, 2b).

9. Housing according to Claim 8,
**characterized in that**
a deformation element (3a, 3b) is in each case arranged between the external connection strips (2a, 2b) and the chip connection region (4).

10. Housing according to one of the preceding claims,
**characterized in that**
the deformation element (3a, 3b) comprises a spring strip, whose strip width is less than the width of the adjoining external connection strip (2a, 2b).

11. Housing according to Claim 10,
**characterized in that**
the spring strip runs transversely with respect to the main direction of extent of the leadframe (1).

12. Housing according to one of the preceding claims,
**characterized in that**
the chip connection region (4) comprises a chip mounting part (14) and a wire connection part (13) arranged at a distance therefrom.

13. Housing according to one of the preceding claims,
**characterized in that**
the external connection strip (2a, 2b), the deformation element (3a, 3b) and a partial region - assigned thereto - of the chip connection region (4) of the leadframe (1) are formed in one piece.

14. Housing according to one of the preceding claims,
**characterized in that**
the leadframe (1) is provided with a surface coating which improves the soldering or bonding properties.

15. Housing according to Claim 6,
**characterized in that**
at least one guide element, in particular a guide projection (10a, 10b, 10c) or a guide groove, is provided at the housing body (80) and interacts with the guide part (9, 9a, 9b) of the leadframe.

16. Housing according to Claim 15,
**characterized in that**
the housing body (80) has a housing base body (8) in which the leadframe (1) is embedded in such a way that the external connection strip (2a, 2b) and at least partly the deformation element (3a, 3b) project from the housing base body (8).

17. Housing according to Claim 16,
**characterized in that**
the housing base body (8) has a circular or oval cross-sectional form parallel to the plane of the external connection strip (2a, 2b).

18. Housing according to Claim 16 or 17,
**characterized in that**
the guide element is arranged at the housing base body (8), in particular is integrally formed at the latter.

19. Housing according to one of Claims 15 to 18,
**characterized in that**
the housing body (80) or the housing base body (8) has a projection (10) as guide element, said projection overlapping the deformation element (3a, 3b) or external connection strip (2a, 2b) to be supported.

20. Housing according to one of Claims 15 to 19,
**characterized in that**
the housing body (80) or the housing base body (8) has a groove into which projects the guide part (9, 9a, 9b) of the deformation element (3a, 3b) or of the external connection strip (2a, 2b).

21. Housing according to one of Claims 1 to 20,
**characterized in that**
the housing body (80) or the housing base body (8) is produced from a molding composition, in particular from a thermoplastic material.

22. Housing according to one of Claims 1 to 21,
**characterized in that**
the housing has a radiation exit window (12), in which the chip connection region (4) of the leadframe (1) is arranged.

23. Surface-mountable radiation-emitting component having a radiation-emitting chip (16),
**characterized in that**
it has a housing according to one of Claims 1 to 22 and a radiation-emitting chip.

24. Surface-mountable radiation-emitting component according to Claim 23,
**characterized in that**
the housing has a radiation exit window (12), in which the chip connection region (4) of the leadframe (1) is arranged and
the radiation exit window (12) is bounded at least partly by side areas which are formed in such a way that they act as a radiation reflector (11) at least for part of a radiation emitted by the radiation-emitting chip arranged in the radiation exit window (12).

25. Surface-mountable radiation-emitting component according to Claim 23 or 24,
**characterized in that**
the radiation-emitting chip (16) is fixed in the chip connection region (4a, 4b) on the leadframe (1) or, if appropriate, on the housing base body (8).

26. Surface-mountable radiation-emitting component according to one of Claims 23 to 25,
**characterized in that**
the radiation-emitting chip (16) is a semiconductor chip.

27. Surface-mountable radiation-emitting component according to Claim 25 or 26,
**characterized in that**
the chip (16) is at least partly encapsulated with a radiation-transmissive composition, in particular a plastics composition.

28. Surface-mountable radiation-emitting component according to Claim 27,
**characterized in that**
the radiation-transmissive composition is a casting resin or a molding composition based on a reaction resin, in particular an epoxy resin, acrylic resin or silicone resin or a mixture of said resins.

29. Arrangement having a plurality of surface-mountable radiation-emitting components according to one of Claims 23 to 28,
**characterized in that**
provision is made of a carrier (19) with a plurality of perforations (20) and the radiation-emitting components are in each case fixed with the external connection strips (2a, 2b) at a component side of the carrier in such a way that their housing body (80) or housing base body (8) in each case projects into or through one of the perforations (20).

30. Arrangement according to Claim 29,
**characterized in that**
the carrier (19) has an emission side (21) which is situated at the carrier's side opposite to the component side, and the components project into or through the perforations (20) in each case with their front side.

31. Arrangement according to Claim 30,
**characterized in that**
the emission-side surface of the carrier (19) is radiation-absorbent, in particular blackened.

32. Arrangement according to Claim 30,
**characterized in that**
the emission-side surface of the carrier (19) is diffusely reflective, in particular white.

33. Arrangement according to one of Claims 30 to 32,
**characterized in that**
a diffusing plate (22) is arranged downstream of the carrier (19) on the emission side.

34. Arrangement according to one of claims 30 to 33,
**characterized in that**
a liquid crystal display is arranged downstream of the carrier (19) on the emission side.

35. Arrangement according to one of Claims 29 to 34,
**characterized in that**
the carrier (19) is formed in flexible fashion.

36. Arrangement according to one of Claims 29 to 35,
**characterized in that**
electrical conduction structures are formed on the carrier (19).

## Revendications

1. Boîtier pour composant émettant un rayonnement, montable en surface, comportant
- un corps de boîtier (80) et
- un cadre conducteur (1) comportant au moins une zone de connexion de puce (4) et au moins une bande de connexion externe (2a,2b) reliée électriquement à celui-ci,
dans lequel entre la zone de connexion de puce (4) et la bande de connexion externe (2a,2b) est réalisé un élément de déformation (3a,3b), lequel s'étend en totalité dans un même plan du cadre conducteur (1) que la bande de connexion externe (2a, 2b) et permet dans un sens parallèle à un plan de montage du boîtier un mouvement de la bande de connexion externe par rapport à la zone de connexion de puce (4), et dans lequel
le cadre conducteur est incorporé dans le corps de boîtier (80) de telle sorte que la bande de connexion externe dépasse à l'extérieur de celui-ci,
**caractérisé en ce que** l'élément de déformation (3a,3b) dépasse au moins partiellement à l'extérieur du corps de boîtier.

2. Boîtier selon la revendication 1,
**caractérisé en ce que** l'élément de déformation (3a,3b) est un élément de ressort.

3. Boîtier selon la revendication 1 ou 2,
**caractérisé en ce que** le cadre conducteur présente entre l'élément de déformation (3a,3b) et la zone de connexion de puce (4) un élément de retenue (6a,6b) pour fixer la zone de connexion de puce (4) dans le logement.

4. Boîtier selon la revendication 3,
**caractérisé en ce qu'**un élément de retenue supplémentaire (6c) est disposé entre la zone de connexion de puce (4) et l'élément de retenue (6a,6b).

5. Boîtier selon la revendication 3 ou 4,
**caractérisé en ce que** l'élément de retenue ou au moins un des éléments de retenue (6a,6b) est une percée ou un évidement dans la zone entre l'élément de déformation (3a,3b) et la zone de connexion de puce (4a,4b), dans laquelle ou lequel vient en prise le corps de boîtier (80).

6. Boîtier selon au moins une des revendications précédentes,
**caractérisé en ce que** l'élément de déformation (3a,3b) ou la bande de connexion externe (2a,2b) présente une partie de guidage (9,9a,9b), notamment une protubérance (9a,9b), qui est soutenue notamment par le corps de boîtier (80) de telle sorte qu'elle agisse contre un gauchissement de la bande de connexion externe (2a,2b) notamment par rapport au côté avant du boîtier.

7. Boîtier selon au moins une des revendications précédentes,
**caractérisé en ce que** le cadre conducteur (1) a une configuration plane en totalité.

8. Boîtier selon au moins une des revendications précédentes, **caractérisé en ce que** le cadre conducteur (1) présente deux bandes de connexion externes (2a,2b).

9. Boîtier selon la revendication 8,
**caractérisé en ce qu'**un élément de déformation (3a,3b) est respectivement disposé entre la bande de connexion externe (2a,2b) et la zone de connexion de puce (4).

10. Boîtier selon une des revendications précédentes,
**caractérisé en ce que** l'élément de déformation (3a,3b) comprend une bande à ressort, dont la largeur de bande est inférieure à la largeur de la bande de connexion externe (2a,2b) contiguë.

11. Boîtier selon la revendication 10,
**caractérisé en ce que** la bande à ressort s'étend transversalement à la direction d'extension principale du cadre conducteur (1).

12. Boîtier selon une des revendications précédentes,
**caractérisé en ce que** la zone de connexion de puce (4) comprend une partie de montage de puce (14) et une partie de connexion de fil (13) disposée à distance de celle-ci.

13. Boîtier selon une des revendications précédentes, **caractérisé en ce que**
la bande de connexion externe (2a,2b), l'élément de déformation (3a,3b) et une zone partielle associée à celui-ci de la zone de connexion de puce (4) du cadre conducteur (1) sont réalisés en un seul tenant.

14. Boîtier selon une des revendications précédentes,
**caractérisé en ce que** le cadre conducteur (1) est pourvu d'un revêtement de surface améliorant les propriétés de liaison ou de brasage.

15. Boîtier selon la revendication 6,
**caractérisé en ce que** sur le corps de boîtier (80) au moins un élément de guidage, notamment une protubérance de guidage (10a,10b,10c) ou une rainure de guidage, est prévu, qui coopère avec la partie de guidage (9,9a,9b) du cadre conducteur.

16. Boîtier selon la revendication 15,
**caractérisé en ce que** le corps de boîtier (80) présente un corps de base de boîtier (8), dans lequel le cadre conducteur (1) est incorporé de telle sorte que la bande de connexion externe (2a,2b) et au moins partiellement l'élément de déformation (3a,3b) dépassent à l'extérieur du corps de base du boîtier (8).

17. Boîtier selon la revendication 16,
**caractérisé en ce que** le corps de base du boîtier (8) présente parallèlement au plan de la bande de connexion externe (2a,2b) une forme de section transversale circulaire ou ovale.

18. Boîtier selon la revendication 16 ou 17,
**caractérisé en ce que** l'élément de guidage est disposé sur le corps de base du boîtier (8), notamment façonné sur celui-ci.

19. Boîtier selon une des revendications 15 à 18,
**caractérisé en ce que** le corps de boîtier (80) ou le corps de base du boîtier (8) présente comme élément de guidage une protubérance (10), qui se superpose à l'élément de déformation (3a,3b) à soutenir ou à la bande de connexion externe (2a,2b).

20. Boîtier selon une des revendications 15 à 19,
**caractérisé en ce que** le corps de boîtier (80) ou le corps de base du boîtier (8) présente une rainure, à l'intérieur de laquelle dépasse la partie de guidage (9,9a,9b) de l'élément de déformation (3a,3b) ou de la bande de connexion externe (2a,2b).

21. Boîtier selon une des revendications 1 à 20,
**caractérisé en ce que** le corps de boîtier (80) ou le corps de base du boîtier (8) est fabriqué dans une matière à mouler, notamment dans une matière thermoplastique.

22. Boîtier selon une des revendications 1 à 21,
**caractérisé en ce que** le logement présente une fenêtre de sortie de rayonnement (12), dans laquelle est disposée la zone de connexion de puce (4) du cadre conducteur (1).

23. Composant émettant un rayonnement, montable en surface, comportant une puce (16) émettant un rayonnement,
**caractérisé en ce qu'**il présente un boîtier selon une des revendications 1 à 22 et une puce émettant un rayonnement.

24. Composant émettant un rayonnement, montable en surface selon la revendication 23,
**caractérisé en ce que** le boîtier présente une fenêtre de sortie de rayonnement (12), dans laquelle est disposée la zone de connexion de puce (4) du cadre conducteur (1) et la fenêtre de sortie de rayonnement (12) est délimitée au moins partiellement par des surfaces latérales, qui sont réalisées de telle sorte qu'elles agissent comme réflecteur de rayonnement (11) au moins pour une partie d'un rayonnement émis par la puce émettant un rayonnement disposée dans la fenêtre de sortie de rayonnement (12).

25. Composant émettant un rayonnement, montable en surface selon la revendication 23 ou 24,
**caractérisé en ce que** la puce (16) émettant un rayonnement est fixée dans la zone de connexion de puce (4a,4b) sur le cadre conducteur (1) ou le cas échéant sur le corps de base du boîtier (8).

26. Composant émettant un rayonnement, montable en surface selon une des revendications 23 à 25,
**caractérisé en ce que** la puce (16) émettant un rayonnement est une puce à semi-conducteurs.

27. Composant émettant un rayonnement, montable en surface selon la revendication 25 ou 26,
**caractérisé en ce que** la puce (16) est enveloppée au moins partiellement avec une masse perméable au rayonnement, notamment une masse plastique.

28. Composant émettant un rayonnement, montable en surface selon la revendication 27,
**caractérisé en ce que** la masse perméable au rayonnement est une résine coulée ou une résine de coulée à base d'une résine à réaction, notamment une résine époxy, une résine acrylique ou une résine silicone ou un mélange de ces résines.

29. Dispositif comportant une pluralité de composants émettant un rayonnement, montables en surface selon une des revendications 23 à 28,
**caractérisé en ce qu'**un support (19) comportant une pluralité de percées (20) est prévu et les composants émettant un rayonnement sont respectivement fixés avec les bandes de connexion externes (2a,2b) sur un côté de composant du support, de telle sorte que leur corps de boîtier (80) ou corps de base de boîtier (8) saille respectivement dans une des percées (20) ou à travers celle-ci.

30. Dispositif selon la revendication 29,
**caractérisé en ce que** le support (19) présente un côté de rayonnement (21), qui se trouve sur un côté de celui-ci en vis-à-vis du côté du composant et les composants saillent respectivement par leur côté avant dans ou à travers les percées (20).

31. Dispositif selon la revendication 30,
**caractérisé en ce que** la surface du support (19) du côté du rayonnement est absorbante de rayonnement, notamment noircie.

32. Dispositif selon la revendication 30,
**caractérisé en ce que** la surface du support (19) du côté du rayonnement est réfléchissante de manière diffuse, notamment blanche.

33. Dispositif selon une des revendications 30 à 32,
**caractérisé en ce qu'**une plaque de diffusion (22) est disposée en aval du support (19) du côté du rayonnement.

34. Dispositif selon une des revendications 30 à 33,
**caractérisé en ce qu'**un écran à cristaux liquides est disposé en aval du support (19) du côté du rayonnement.

35. Dispositif selon une des revendications 29 à 34,
**caractérisé en ce que** le support (19) a une configuration flexible.

36. Dispositif selon une des revendications 29 à 35,
**caractérisé en ce que** des structures de conduction électrique sont réalisées sur le support (19).
